# EUROPEAN PATENT APPLICATION

(11) **EP 1 881 747 A1**
(43) Date of publication of application: **23.01.2008**
(21) Application number: 07012749.3
(22) Date of filing: 29.06.2007
(51) Int. Cl.: H05K 1/02, H05K 9/00, G02F 1/13

(54) **Printed circuit board and electronic device having the same**

(30) Priority: 10.07.2006 KR 20060064305
(71) Applicant: SAMSUNG ELECTRONICS CO., LTD., Yeongtong-gu Suwon-city Gyeonggi-do 442-742 (KR)
(72) Inventor: Lee, Hyun-Su, Gyeonggi-do (KR); Lee, Byoung-Jun, Chungcheongnam-do (KR)
(74) Representative: Dr. Weitzel & Partner

(57) **Abstract**

A driving element and a wiring section electrically connected to the driving element are formed on a base substrate. A first ground pattern outputting a reference voltage of the driving element is formed on the base substrate. The base substrate includes a second ground pattern which is spaced apart from the first ground pattern. An external connection section is included on the base substrate, the external connection section being connected to the first and second ground patterns. A connecting cable contacts the external connection section to permit the first and second ground patterns to be connected to external circuitry.

## Description

### CROSS-REFERENCE TO RELATED APPLICATIONS

This application claims priority under 35 U.S.C. § 119 to Korean Patent Application No. 10-2006-64305 filed on July 10, 2006 in the Korean Intellectual Property Office (KIPO), the contents of which are herein incorporated by reference in their entirety.

### BACKGROUND OF THE INVENTION

### 1. Field of the Invention

The present invention relates to a printed circuit board and an electronic device having the printed circuit board. More particularly, the present invention relates to a printed circuit board capable of enhancing a display quality of an image and an electronic device having the printed circuit board.

### 2. Description of the Related Art

Recently, electronic devices such as liquid crystal display (LCD) devices, notebook computers, and digital versatile disc (DVD) players have been developed. Generally, in such electronic devices a reference voltage thereof attends to fluctuate due to static electricity generated from outside the device.

An LCD device displays an image using a liquid crystal. An LCD device has the advantageous gualities of being light weight, having lower power consumption, and requiring lower driving voltages when compared to other types of display devices.

Generally, an LCD device includes a display unit, a backlight assembly and a top chassis. The display unit displays an image using an optical transmissivity of the liquid crystal. The backlight assembly is disposed below the display unit to provide light to the display unit. The top chassis is coupled to the backlight assembly.

The display unit includes a LCD panel, a printed circuit board (PCB) and a flexible printed circuit board (FPCB). The LCD panel further includes an array substrate, a color filter substrate and a liquid crystal layer. Circuits on the PCB generate a driving signal to drive the LCD panel. The FPCB is interposed between the LCD panel and the LCD to be electrically connected to the LCD panel and the PCB. Typically, a ground of the PCB is electrically connected to the top chassis by a conductive tape.

The LCD device may be influenced by a static electricity generated from the outside of the LCD device, so that the displayed image may flicker. In detail, when the static electricity is applied to the ground of the PCB by the top chassis and the conductive tape, the ground of the PCB becomes unstable so that the image is not properly displayed. Particularly, when the PCB has a single layered structure having a circuit formed on a surface of a base substrate or a double layered structure having a circuit formed on two surfaces of a base substrate, the PCB may be more influenced by the static electricity.

For example, when the PCB has a double layer structure, a driving element and a ground pattern thereof are typically formed on a first surface of the base substrate, and a wiring for the foregoing is formed on a second surface of the base substrate. The ground pattern is connected to the top chassis by the conductive tape. Here, when the static electricity generated from the outside is applied to the top chassis, the static electricity is then applied to the ground pattern through the conductive tape. As a result, a reference voltage of the ground pattern is changed, so that the driving element may not properly function.

Accordingly, when the static electricity generated from the outside of the electronic device is applied to the electronic device, the reference voltage of the electronic device is changed, thereby causing a malfunctioning of the electronic device.

### SUMMARY OF THE INVENTION

The present invention provides a printed circuit board capable of preventing a reference voltage from swinging by a static electricity generated from the outside.

The present invention also provides an electronic device having the above-mentioned printed circuit board.

In one aspect of the present invention, a printed circuit board includes a base substrate, at least one driving element, a wiring section, a first ground pattern, a second ground pattern and an external connection section.

The driving element is formed on the base substrate. The wiring section is formed on the base substrate. The wiring section is electrically connected to the driving element. The first ground pattern is positioned on a surface of the base substrate. The first ground pattern is electrically connected to the at least one driving element. The second ground pattern is positioned on the base substrate. The second ground pattern is spaced apart from the first ground pattern so as to prevent from chaning the reference voltage. The external connection section is electrically connected to the first and second ground patterns. The external connection section is adapted to be electrically connected the first and second ground patterns to a circuit external of the PCB.

For example, the PCB is associated with an electronic device, and the second ground pattern includes a ground connection section that is electrically connected to the electronic device, and a ground circuit section that electrically connects the external connection section.

In another aspect of the present invention, an electronic device includes an electronic module, a conductive receiving member surrounding the electronic module to receive the electronic module, a printed circuit board (PCB) electrically connected to the electronic module to control the electronic module and a ground member grounding to the PCB and the conductive fixing member.

For example, the PCB includes a base substrate, at least one a driving element, a wiring section, a first ground pattern, a second ground pattern and an external connection section. The driving element is formed on the base substrate. The wiring section is formed on the base substrate. The wiring section is electrically connected to the driving element. The first ground pattern is positioned formed on a surface of the base substrate. The first ground pattern is electrically connected to the at least one outputs a reference voltage of the driving element. The second ground pattern is positioned formed on the base substrate. The second ground pattern is to be electrically spaced apart separated from the first ground pattern so as to prevent from changing the reference voltage. The second ground pattern is electrically connected to a first ground part from the outside. The external connection section is electrically connected to the first and second ground patterns. The external connection section is adapted to electrically be connected to the first and a second ground patterns to a circuit external of the PCB part from the outside.

For example, the electronic device includes a display panel displaying an image and flexible PCBs electrically connected to the PCB and the display panel, respectively. Here, the electronic module is disposed below the display panel to provide the display panel with light.

According to the above, a ground pattern is divided into the first ground pattern and the second ground pattern, so that a generated static electricity is emitted to the outside through the second ground pattern. Thus, changes in a reference voltage of the electronic device are prevented.

### BRIEF DESCRIPTION OF THE DRAWINGS

The above and other advantages of the present invention will become readily apparent by reference to the following detailed description when considered in conjunction with the accompanying drawings wherein:
FIG. 1 is a block diagram schematically illustrating an electronic device according to an embodiment of the present invention;
FIG. 2 is an exploded perspective view illustrating an electronic device according to another embodiment of the present invention;
FIG. 3 is a perspective view illustrating a portion of a rear surface of the electronic device in FIG. 2;
FIG. 4 is a plan view illustrating a first surface of a printed circuit board of the display device in FIG. 2; and
FIG. 5 is a plan view illustrating a second surface of the printed circuit board of the display device in FIG. 2.

### DESCRIPTION OF THE EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although terms such as first, second, and third may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The present invention is described below in detail with reference to the accompanying drawings.

### Example Embodiment 1 (Electronic Device)

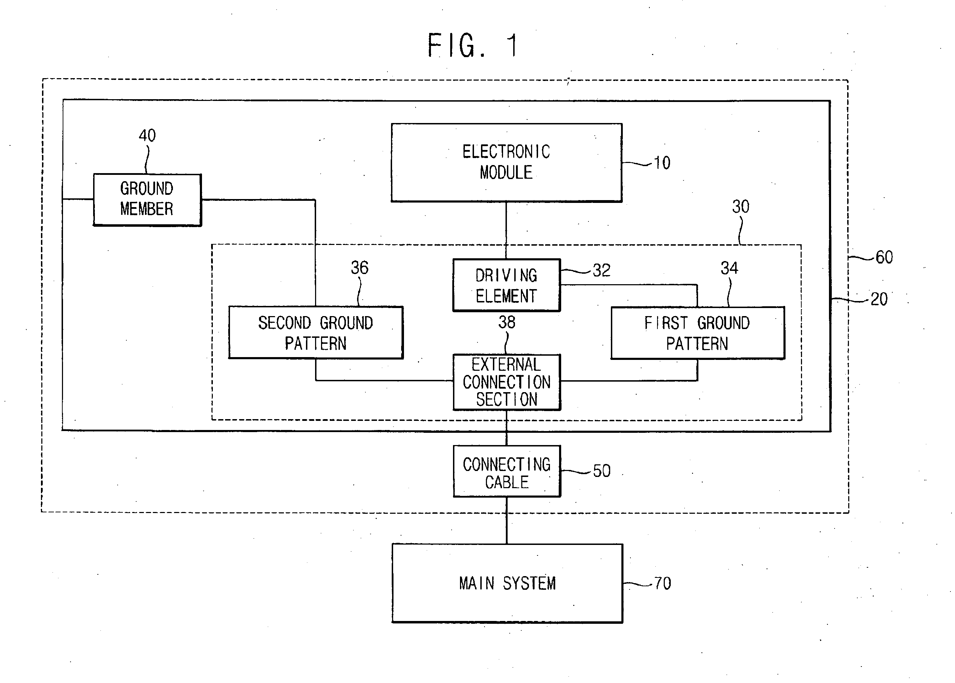

FIG. 1 is a block diagram schematically illustrating an electronic device according to an embodiment of the present invention.

Referring to FIG. 1, an electronic device 60 according to one embodiment of the present invention includes an electronic module 10, a conductive fixing member 20, a printed circuit board (PCB) 30 and a ground member 40. The electronic device 60 optionally further includes a connecting cable 50.

The electronic module 10 includes an electronic circuit therein, and receives a power source voltage to perform various functions. For example, when the electronic module 10 is a display panel, the electronic module 10 performs to display an image thereon.

The conductive fixing member 20 surrounds the electronic module 10 to secure the electronic module 10. For example, the conductive fixing member 20 includes a conductive metal material.

The PCB 30 is electrically connected to the electronic module 10 and controls the electronic module 10. That is, the PCB 30 generates driving signals for controlling the electronic module 10 and provides the electronic module 10 with the driving signals. The PCB 30 is electrically connected to a main system 70 through the connecting cable 50. As a result, the PCB 30 is controlled by the main system 70.

The ground member 40 electrically connects the conductive fixing member 20 to the PCB 30, so that the PCB 30 is grounded to the conductive fixing member 20. For example, the ground member 40 may be a conductive tape. More particularly, the ground member may be an aluminum tape.

The PCB 30 includes a base substrate (not shown), a driving element 32, a wiring section (not shown), a first ground pattern 34, a second ground pattern 36 and an external connection section 38.

The base substrate may have a plate shape. For example, the base substrate may include an insulative resin.

The driving element 32 is formed on the base substrate to generate driving signals for controlling the electronic module 10. A plurality of the driving elements 32 are electrically connected to a wiring section.

The first ground pattern 34 is formed on the base substrate and electrically connected to the driving element 32. The first ground pattern 34 provides the driving element 32 with a reference voltage.

The second ground pattern 36 is formed on the base substrate and is electrically separated from the first ground pattern 34, and is connected to the conductive fixing member 20 by the ground member 40.

The external connection section 38 is electrically connected to the first ground pattern 34 and the second ground pattern 36, respectively. The external connection section 38 is electrically connected to the main system 70 through a connecting cable 50, and the external connection section 38 is electrically connected to a system ground of the main system 70.

The external connection section 38 is electrically connected to the system ground of the main system 70, so that the first and second ground patterns 34 and 36 and the conductive fixing member 20 are electrically connected to the system ground of the main system 70.

Hereinafter, an effection of the present example embodiment is described in detail in consideration of a moving path of a static electricity generated from the outside.

When a static electricity is generated from the outside of the electronic device 60, the generated static electricity is applied to the conductive fixing member 20. The static electricity applied to the conductive fixing member 20 is applied to the second ground pattern 36 through the ground member 40, and is then applied to the external connection section 38.

A portion of the static electricity applied in the external connection section 38 is applied to the first ground pattern 34, and a remaining portion of the static electricity is applied in the system ground of the main system 70 through the connecting cable 50. Here, because the size of the system ground of the main system 70 is generally greater than that of the first ground pattern 34, the majority of static electricity applied to external connection section 38 is applied to the system ground of the main system 70 through the connecting cable 50.

The majority of static electricity generated from the outside of the electronic device 60 is applied to the system ground of the main system 70 through the second ground pattern 36, thereby preventing a reference voltage of the first ground pattern 34 from being fluctuated by the static electricity. As a result, even though the static electricity is generated from the outside, the driving element 32 may stably control the electronic module 10 using a reference voltage of the first ground pattern 34.

However, when the first and second ground patterns 34 and 36 are integrated to each other, static electricity generated from the outside of the electronic device 60 is applied to the integrated ground pattern. Thus, the reference voltage is directly changed, and thus the electronic module 10 may not be stably controlled by the driving element 32.

### Example Embodiment 2 (Electronic Device)

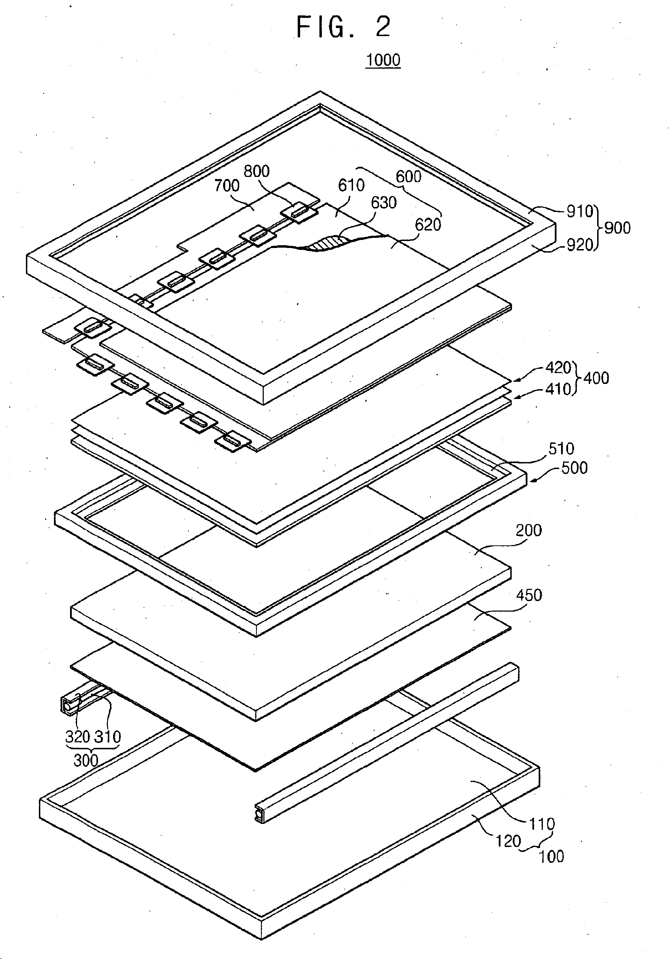

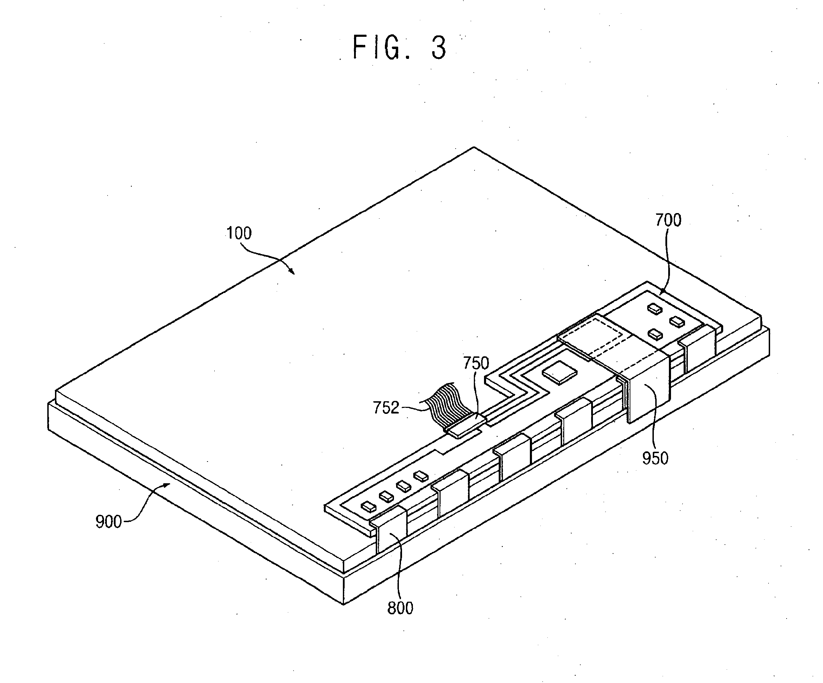

FIG. 2 is an exploded perspective view illustrating an electronic device according to another embodiment of the present invention. FIG. 3 is a perspective view illustrating a portion of a rear surface of the electronic device in FIG. 2.

Referring to FIGS. 2 and 3, an electronic device according to the present embodiment is a display device 1000 for displaying an image. The display device 1000 includes a display unit (not shown), a backlight assembly (not shown), a top chassis 900 and a ground member 950. The display unit displays an image. A backlight assembly is disposed below the display unit to provide the display unit with light. The top chassis is coupled to the backlight assembly to fix the display unit. The ground member 950 provides a common ground between the display unit and the top chassis 900.

The backlight assembly includes a receiving container 100, a light guiding plate 200, a light generating unit 300, optical sheets 400 and a reflecting sheet 450. The backlight assembly may further include a mold frame 500.

The receiving container 100 includes a receiving bottom section 110 and a plurality of receiving wall sections. 120 which extend from edge portions of the receiving bottom section 110. The receiving container 100 receives the light guiding plate 200, the light generating unit 300, the optical sheets 400, the reflecting sheet 450 and the mold frame 500. An opening may be formed through the receiving bottom section 110.

In one example, the light guiding plate 200 has a rectangular shape, and is disposed within the receiving container 100. Two light generating units 300 are respectively disposed on two sidewalls of the light guiding plate 200 each of which faces with each other. For another example, the light generating unit 300 may be disposed to face one sidewall of the light guiding plate 200. Alternatively, the light generating unit 300 may be disposed at one sidewall of the light guiding plate 200, and the light guiding plate 200 may be wedge shaped having a thickness that decreases from the light generating unit 300.

In this example embodiment, the light generating unit 300 includes a lamp 310 and a lamp cover 320.

The lamp 310 is, for example, a cold cathode fluorescent lamp (CCFL) generating low heat, and having a long lifetime and being rod-shaped. The lamp cover 320 surrounds a portion of the lamp 310. The lamp cover 320 reflects light generated from the lamp 310 toward a sidewall of the light guiding plate 200.

The incident light at a sidewall of the light guiding plate 200 is refracted and reflected in an inner portion of the light guiding plate 200 to emit an upper portion of the light guiding plate 200. A plurality of reflection patterns (not shown) may be formed on a lower surface of the light guiding plate 200, which changes a light path by diffusing or scattering the incident light in the light guiding plate 200.

The light generating unit 300 may be disposed below the light guiding plate 200. When the light generating unit 300 is disposed below the light guiding plate 200, the light generating unit 300 may consist of a plurality of lamps which are received in the receiving container 100 and arranged substantially in parallel with each other below the light guiding plate 200.

The optical sheets 400 are disposed on or over the light guiding plate 200 to guide the light that passes through the light guiding plate 200 to improve optical characteristics of the light. The optical sheets 400 may enhance, for example, a front luminance of the light and a luminance uniformity of the light.

For example, the optical sheets 400 may include a diffusion sheet and a condensing sheet. The diffusion sheet diffuses the light that is guided by the light guiding plate 200 to increase the luminance uniformity. The condensing sheet reflects and refracts the diffused light from the diffusion sheet to increase a front luminance of the light. The optical sheets 400 may further include additional sheets. Alternatively, one or more of the optical sheets 400 may be omitted.

The reflection sheet 450 is disposed under the light guiding plate 200 and is received in the receiving container 100. The reflection sheet 450 reflects the light leaked from the light guiding plate 200 toward the light guiding plate 200. Light that is reflected by the reflection sheet 450 enters the light guiding plate 200. In example embodiments, the reflection sheet 450 may include a high-reflectivity material. In an example embodiment, the reflection sheet 450 includes polyethylene terephthalate (PET) or polycarbonate (PC).

The mold frame 500 is disposed on an upper portion of the light guiding plate 200. The mold frame 500 applies pressure to an upper portion of the lamp cover 320 to secure the lamp cover 320 in receiving container 100. A central portion of the mold frame 500 is open to pass light, and the optical sheets 400 are disposed in the open portion. Alternatively, the mold frame 500 that may have a stepped portion 510 formed thereon to receive an edge portion of the display panel 600 which is described below.

The display unit includes a display panel 600, a printed circuit board (PCB) 700 and a flexible printed circuit board (FPCB) 800.

The display panel 600 is supported by stepped portion 510 of the mold frame 500 and disposed on the optical sheets 400. The display panel 600 displays an image using light transmitted through the optical sheets 400. The display panel 600 includes a first substrate 610, a second substrate 620 and a liquid crystal layer 630.

The first substrate 610 includes a plurality of pixel electrodes, a plurality of thin-film transistors (TFTs), and a plurality of signal lines. The pixel electrodes are arranged in a matrix shape. Each of the TFTs applies a driving voltage to the pixel electrodes, respectively. Each of the signal lines transfers the driving voltage to the TFTs, respectively.

The second substrate 620 is aligned with and is spaced apart from the first substrate 610. The second substrate 620 includes a base substrate, a common electrode and a plurality of color filters. The common electrode having a transparent conductive material is disposed on the base substrate. The color filters are disposed on areas that are opposite to the pixel electrodes. The color filters include, for example, a red color filter, a green color filter, and a blue color filter. Each of the red, green, and blue color filters is provided in respective pixel electrodes.

The liquid crystal layer 630 is interposed between the first and second substrates 610 and 620. An arrangement of liquid crystal molecules of the liquid crystal layer 630 is changed in response to an electric field generated between the pixel electrode and the common electrode, thereby changing a light transmittance of the liquid crystal layer 630 to display an image.

The PCB 700 generates driving signals that control the display panel 600. In the embodiment of FIG. 2, the PCB 700 only includes a data PCB. Alternatively, the PCB 700 may further include a gate PCB. A detailed description of the PCB 700 is described below with reference to additional drawings.

The FPCB 800 is electrically connected to the PCB 700 and the first substrate 610 to transmit driving signals generated from the PCB 700 to the first substrate 610. When the FPCB 800 is bent, the PCB 700 may be disposed under the display panel 600.

The top chassis 900 includes a chassis upper portion 910 that receives an edge portion of the display panel 600 and a chassis side portion 920 that extends from the edge portion of the chassis upper portion 910. The chassis side portion 920 is combined with a receiving side portion 120 of the receiving container 100, and the chassis upper portion 910 presses against the edge portion of the display panel 600 to support the display panel 600.

The top chassis 900 includes a conductive metal material. The top chassis 900 provides protection to display panel 600 which is brittle and can be broken or damaged by an external impact or vibration. Furthermore, the top chassis 900 may prevent the separation of the display panel 600 from the receiving container 100.

The ground member 950 grounds the PCB 700 of the display unit to the top chassis 900. For example, the ground member 950 connects a ground pattern of the PCB 700 to the chassis side portion 920 of the top chassis 900. The ground member 950 includes a conductive tape having coated thereon an adhesive material. For example, the ground member 950 may be an aluminum tape.

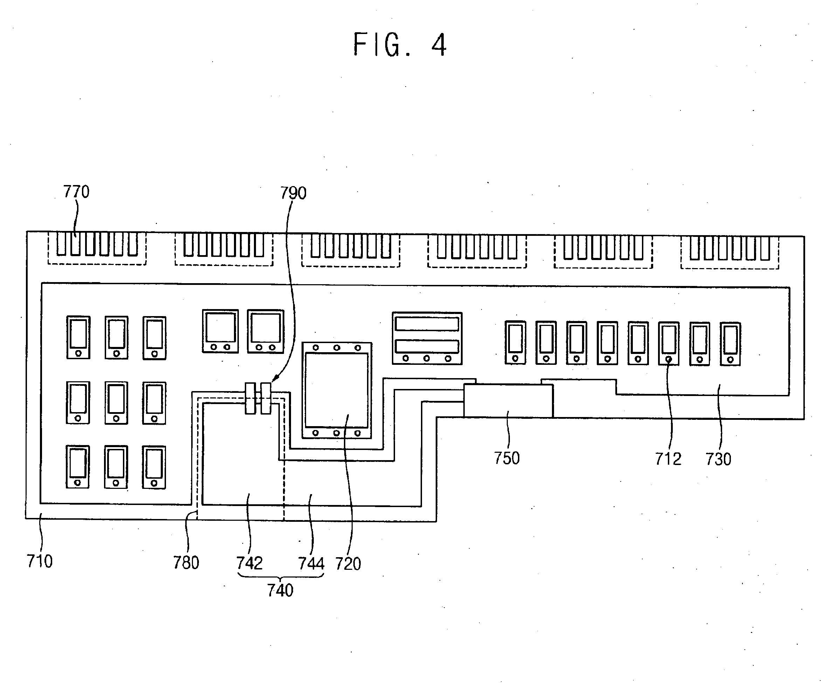

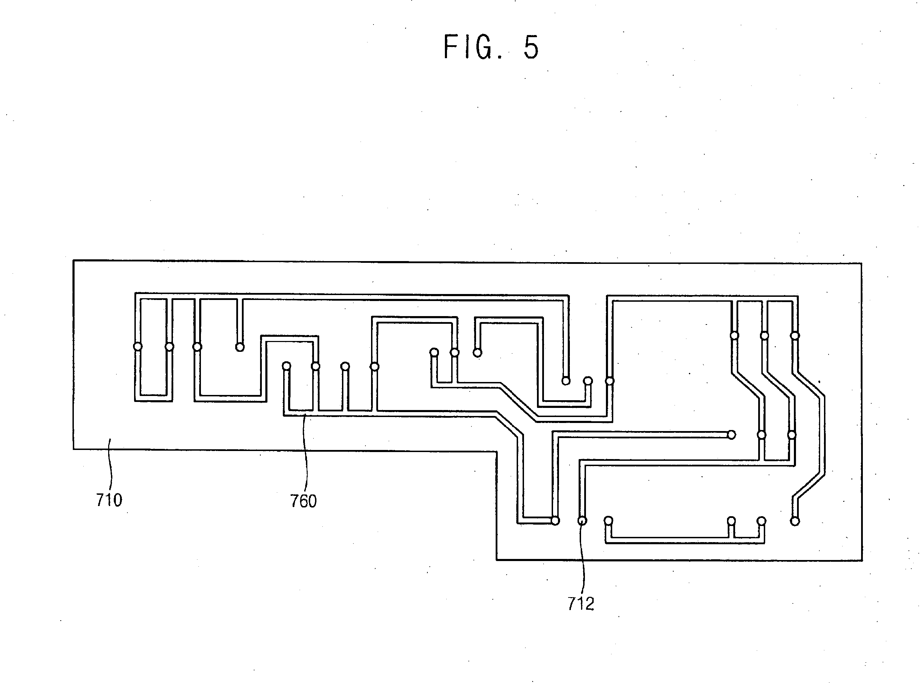

FIG. 4 is a plan view illustrating a first surface of a printed circuit board (PCB) of the display device in FIG. 2. FIG. 5 is a plan view illustrating a second surface of the PCB of the display device in FIG. 2.

Referring to FIGS. 3, 4 and 5, a PCB 700 according to the present example embodiment includes a base substrate 710, a driving element 720, a first ground pattern 730, a second ground pattern 740, an external connection section 750, a pad sections 770, 770-1, 770-2, 770-3 770-4 and 770-5 and a protective layer 780. The PCB 700 optionally further includes a passive element 790.

The base substrate 710 may have a substantial plate shape, and include, for example, an insulation resin material. For example, the base substrate 710 may have an L-shape when viewed on a plane.

A plurality of the driving elements 720 is disposed on a first surface of the base substrate 710. The driving elements 720 are electrically connected one another by the wiring section 760 shown in FIG. 5. The driving elements 720 generate driving signals for controlling the display panel 600.

The first ground pattern 730 is formed on the first surface of the base substrate 710, and is electrically connected to the driving elements 720. First ground pattern 730 is also connected to external connection section 750 by connection portion 730-1 as shown in FIG. 4. The first ground pattern 730 provides the driving elements 720 with a reference voltage.

The second ground pattern 740 is also formed on the first surface of the base substrate 710 and is spaced apart from the first ground pattern 730. The second ground pattern 740 is electrically connected to the top chassis 900 by the ground member 950. The second ground pattern 740 may be formed in an area of the first surface of the base substrate 710, which is different from an area that the driving element 720 is formed thereon.

The second ground pattern 740 includes a ground connection section 742 and a ground circuit section 744. The ground member 950 is directly adhered to the ground connection section 742, so that the ground connection section 742 is electrically connected to the top chassis 900 through the ground member 950. The ground connection section 742 may have a substantially rectangular shape when viewed in a plan view of the display device. The ground circuit section 744 extends from the ground connection section 742 and is electrically connected to the external connection section 750 by ground connection portion 740A.

The external connection section 750 is electrically connected at the ground connection section 742 by the ground circuit section 744, and the external connection section 750 is also electrically connected to the first ground pattern 730. Therefore, the first and second ground patterns 730 and 740 are electrically connected to each other by the external connection section 750.

The external connection section 750 may include a connection socket that is coupled to an external connecting cable 752. The external connection section 750 is electrically connected to an external main system (not shown) through the connecting cable 752. That is, the main system generates a control signal for control the driving elements 720, and applies the control signal to the external connection section 750 through the connecting cable 752.

The external connection section 750 is electrically connected to the system ground of the main system by the connecting cable 752 As a result, the first and second ground patterns 730 and 740 and the top chassis 900 are electrically connected to the system ground of the main system.

As shown in FIG. 5, the wiring section 760 is formed on a second surface of the base substrate 710 that is opposite to the first surface of the base substrate 710. The driving elements 720, the first and second ground patterns 730 and 740 are formed on the first surface of the base substrate 710, and the wiring section 760 connected to the driving elements 720 is formed on the second surface of the base substrate 710.

A via hole 712 is formed on the base substrate 710, and electrically connects between the driving element 720 and the wiring section 760. The wiring section 760 is electrically connected to the driving element 720 through the via hole 712.

The pad sections 770, 770-1, 770-2, 770-3, 770-4 and 770-5 are formed on a portion of the first surface of the base substrate 710 along a line. For example, the pad section 770 may be formed on a first portion of the first surface of the base substrate 710, which is opposite to the external connection section 750. The pad sections are electrically connected to the driving elements 720 by the wiring section 760.

The pad section 770 is electrically connected to the flexible printed circuit board (FPCB) 800. The driving signal generated from the driving element 720 is applied to the first substrate 610 of the display panel 600 via the pad section 770 and the FPCB 800.

The protecting layer 780 is formed on the first and second surfaces of the base substrate 710, and covers the first and second ground patterns 730 and 740 and the wiring section 760 to protect the first and second ground patterns 730 and 740 and the wiring section 760. First and second openings are formed through the protecting layer 780. The first opening may expose the ground connection section 742 of the second ground pattern 740 toward the outside. The second opening may expose the pad section 770.

The passive element 790 is optionally formed on the first surface of the base substrate 710, and is interposed between the first and second ground patterns 730 and 740. The passive element 790 is electrically connected to the first and second ground patterns 730 and 740. The passive element 790 may include at least one of a capacitor and a resistor.

Accordingly, when the passive element 790 having a resistor and a capacitor is interposed between the first and second ground patterns 730 and 740, a charge quantity of a direct current is controlled by the resistor, and a charge quantity of an alternative current is controlled by the capacitor. The charge quantity of a direct current and that of an alternating current are applied from the second ground pattern 740 to the first ground pattern 730. For example, when a resistance of the passive element 790 is high, a movement of charge between the first and second ground patterns 730 and 740 is suppressed so that the amount of static electricity applied to the first ground pattern 730 will be decreased. However, when the a resistance of the passive element 790 is low, a movement of charge between the first and second ground patterns 730 and 740 is freer so that a quantity of static electricity applied to the first ground pattern 730 may be increased .

Lastly, an operation of the present example embodiment will be described in detail in consideration of a moving path of a static electricity generated from the outside.

When a static electricity is generated from the outside of the display device 1000, the static electricity is applied to the second ground pattern 740 through the ground member 950, and is then applied to the external connection section 750. The majority of static electricity applied into the external connection section 750 is applied to the system ground of the main system 70 (shown in FIG. 1) through the connecting cable 752.

Accordingly, the majority of static electricity generated from the outside of the display device 1000 is applied to the system ground through the second ground pattern 740, thereby preventing a reference voltage of the first ground pattern 730 from fluctuating as a consequent of the static electricity. As a result, even when the static electricity is generated from the outside of the display device 1000, the driving element 720 of the PCB 700 may stably control the display panel 600 using a reference voltage of the first ground pattern 730.

According to the present invention, the ground pattern of the PCB is divided into the first and second ground patterns that are spaced apart from each other, so that a static electricity generated from the outside of the electronic device is applied to the system ground of the main system through the second ground pattern. As a result, the static electricity generated from the outside is prevented from changing the reference voltage of the first ground pattern, so that the driving element of the PCB may stably control the electronic module.

Although the example embodiments of the present invention have been described, it is understood that the present invention should not be limited to these example embodiments but various changes and modifications can be made by one ordinary skilled in the art within the spirit and scope of the present invention as hereinafter claimed.

## Claims

1. A printed circuit board (PCB) comprising:
a base substrate;
at least one driving element located on the base substrate;
a wiring section formed on the base substrate, the wiring section being electrically connected to the driving element;
a first ground pattern positioned on a surface of the base substrate, the first ground pattern being electrically connected to the at least one driving element;
a second ground pattern positioned on the base substrate, wherein the second ground pattern is spaced apart from the first ground pattern so as to prevent from changing the reference voltage; and
an external connection section electrically connected to the first and second ground patterns, the external connection section being adapted to electrically connect the first and second ground patterns to a circuit external of the PCB.

2. The PCB of claim 1, wherein the PCB is associated with an electronic device, and further wherein the second ground pattern comprises:
a ground connection section that is electrically connected to the electronic device; and
a ground circuit section that is electrically connected to the external connection section.

3. The PCB of claim 1, wherein the at least one driving element is positioned on a first surface of the base substrate, and the wiring section is formed on a second, different surface of the base substrate.

4. The PCB of claim 3, wherein the first and second ground patterns are formed on the first surface of the base substrate.

5. The PCB of claim 4, further comprising a protective layer positioned on the first and second surfaces of the base substrate to cover the first and second ground patterns and the wiring section.

6. The PCB of claim 5, wherein the protective layer includes an opening to expose the ground connection section.

7. The PCB of claim 3, wherein the base substrate includes a via hole, and the at least one driving element is connected to the wiring section through the via hole.

8. The PCB of claim 1, further comprising:
at least one passive element having one terminal connected to the first ground pattern and another terminal connected to the second ground pattern.

9. The PCB of claim 8 wherein the at least one passive element comprises at least one of a capacitor and a resistor.

10. The PCB of claim 1, wherein the first ground part comprises a conductive fixing member, and the second ground part comprises a system ground of a main system.

11. An electronic device having a printed circuit board according to claim 1, the electronic device further comprising:
an electronic module;
a conductive receiving member surrounding the electronic module to receive the electronic module; and
a ground member connected to the PCB and the conductive receiving member wherein the printed circuit board (PCB) is electrically connected to the electronic module.

12. The electronic device of claim 11, wherein the second ground pattern comprises:
a ground connection section that is electrically connected to the electronic device; and
a ground circuit section that is electrically connected to the external connection section.

13. The electronic device of claim 11, wherein the at least one driving element is positioned on a first surface of the base substrate, and the wiring section is formed on a second, different surface of the base substrate.

14. The electronic device of claim 13, wherein the first and second ground patterns are formed on the first surface of the base substrate.

15. The electronic device of claim 14, further comprising a protective layer formed on the first and second surfaces of the base substrate to cover the first and second ground patterns and the wiring section, and
wherein the protective layer includes an opening to expose the ground connection section.

16. The electronic device of claim 11, further comprising:
at least one passive element having one terminal connected to the first ground pattern and another terminal connected to the second ground pattern.

17. The electronic device of claim 11, wherein the ground member comprises a conductive tape.

18. The electronic device of claim 11, further comprising a connecting cable connected to the external connection section of the PCB.

19. The electronic device of claim 11, wherein the electronic device further comprises:
a display panel; and
a flexible printed circuit board electrically connecting the PCB to the display panel.

20. The electronic device of claim 19, wherein the electronic module is adapted to provide light to the display panel.
